# FASCICULE DE BREVET EUROPEEN

(11) **EP 4 022 107 B1**
(45) Date de publication et mention de la délivrance du brevet: **02.08.2023**
(21) Numéro de dépôt: 20768406.9
(22) Date de dépôt: 04.09.2020
(51) Int. Cl.: B05B 5/025, C23C 14/24, B05D 1/00, C23C 14/26, C23C 14/54, H01J 27/26, B05B 7/16, B05B 5/00

(54) **PROCEDE D'EMISSION D'ATOMES, DE MOLECULES OU D'IONS**
VERFAHREN ZUM EMITTIEREN VON ATOMEN, MOLEKÜLEN ODER IONEN
METHOD FOR EMITTING ATOMS, MOLECULES OR IONS

(30) Priorité: 10.09.2019 FR 1909936
(43) Date de publication de la demande: 06.07.2022
(73) Titulaire: Centre national de la recherche scientifique, 75016 Paris (FR); Université d'Aix Marseille, 13284 Marseille Cedex 07 (FR)
(72) Inventeur: DEGIOVANNI, Alain, 13001 Marseille (FR); DAINECHE, Rachid, 13110 Port de Bouc (FR)
(74) Mandataire: de Jong, Jean Jacques
(86) Numéro de dépôt international: PCT/IB2020/058243
(87) Numéro de publication internationale: WO 2021/048719

(56) Documents cités:
- EP-A1- 0 706 199
- FR-A1- 2 116 212
- FR-A1- 2 918 790
- JP-A- S5 954 156
- US-A- 4 638 217
- US-A- 4 774 413

## Description

La présente invention concerne une source de matière émise sous la forme d'atomes, de molécules ou d'ions, utilisable notamment pour réaliser des micro- ou nanostructures sur un substrat, notamment dans le domaine de la microélectronique et des nanotechnologies. Les flux d'ions peuvent également être utilisés en spectrométrie de masse d'ions secondaires (Secondary Ion Mass Spectrometry - SIMS), dans un microscope à faisceau de particules chargées (charged-particle microscope), dans un système d'implantation ionique, ou dans une sonde ionique focalisée (focused ion beam - FIB).

De telles micro- ou nanostructures sont généralement réalisées en microélectronique en faisant appel à des techniques complexes, telles que la lithographie, MBE (Molecular Beam Epitaxy), CVD (Chemical Vapor Déposition), et FIB (Focused Ion Beam).

Il est souhaitable de réaliser une source de matière utilisable pour réaliser des micro- ou nanostructures, qui soit compacte, et dont la fabrication fait intervenir des moyens simples ou peu coûteux. Il peut également être souhaitable que cette source de matière puisse être activée et désactivée à l'aide de moyens de commande simples et présentant des temps de réponse réduits.

Des modes de réalisation concernent un procédé pour émettre un flux de matière, le procédé comprenant des étapes consistant à : prévoir un tube capillaire comportant au moins une ouverture formant une buse, introduire de la matière à émettre sous forme solide ou liquide, dans le tube capillaire, disposer le tube capillaire de manière à ce que la buse soit orientée vers une cible, et chauffer le tube capillaire à une température correspondant à une pression de vapeur saturante souhaitée de la matière présente dans le tube, pour éjecter la matière sous forme de vapeur hors du tube par la buse.

Selon un mode de réalisation, le procédé comprend une étape de fermeture d'une première extrémité ouverte du tube capillaire en chauffant le tube capillaire à une température de fusion du tube capillaire, au voisinage de la première extrémité ouverte.

Selon un mode de réalisation, le procédé comprend une étape de formation de la buse en chauffant une seconde extrémité ouverte du tube capillaire à une température de fusion du tube capillaire, la buse présentant un orifice de sortie ayant un diamètre inférieur à un diamètre interne du tube capillaire.

Selon un mode de réalisation, la buse présente un profil effilé obtenu en chauffant une partie centrale du tube capillaire au voisinage de sa température de fusion, et en écartant les extrémités du tube capillaire pour étirer la partie centrale chauffée.

Selon un mode de réalisation, le procédé comprend une étape d'arrêt du chauffage du tube capillaire pour stopper l'émission du flux de matière.

Selon un mode de réalisation, le chauffage du tube capillaire pour émettre la matière, est réalisé en plaçant le tube capillaire dans un four.

Selon un mode de réalisation, le procédé comprend des étapes de déplacement relatif, de manière contrôlée, du tube capillaire par rapport à un substrat, pendant que le tube capillaire est chauffé, pour former sur le substrat des structures de formes et d'épaisseurs prédéfinies.

Selon un mode de réalisation, le procédé comprend une étape d'ionisation de la matière dans le tube capillaire au moyen d'un champ électrique généré dans le tube capillaire.

Selon un mode de réalisation, le procédé comprend une étape de placement de la source de matière dans une atmosphère contrôlée en pression et/ou en composition.

Des modes de réalisation peuvent également concerner un dispositif pour émettre un flux de matière vaporisée, le dispositif comprenant : un tube capillaire renfermant la matière à émettre, le tube capillaire étant fermé à une première extrémité, et comportant une buse de sortie de la matière à une seconde extrémité, un dispositif de chauffage dans lequel le tube capillaire est disposé, et un organe de commande du dispositif de chauffage pour déclencher l'émission d'un flux de matière vaporisée hors du tube par la buse en activant le chauffage du tube capillaire à une température correspondant à une pression de vapeur saturante souhaitée de la matière présente dans le tube, ou stopper l'émission du flux de matière vaporisée.

Selon un mode de réalisation, la buse présente un profil effilé.

Selon un mode de réalisation, le dispositif de chauffage comprend une bobine formant un logement cylindrique dans lequel le tube capillaire est introduit, la bobine étant configurée pour : produire de la chaleur par effet Joule lorsqu'elle est traversée par un courant électrique, le courant électrique étant fourni à la bobine par conduction ou par induction, ou bien chauffer directement par induction la matière dans le tube capillaire.

Selon un mode de réalisation, le dispositif de chauffage comprend un écran thermique entourant le tube capillaire.

Selon un mode de réalisation, le dispositif comprend un dispositif de déplacement relatif, de manière contrôlée, du tube capillaire par rapport à un substrat, la buse étant placée en regard du substrat, pour former une micro- ou nanostructure sur le substrat.

Selon un mode de réalisation, le dispositif comprend une électrode interne et une électrode externe disposées respectivement dans le tube capillaire et à l'extérieur du tube capillaire, pour générer un champ électrique apte à ioniser la matière avant son éjection hors du tube capillaire.

Il est fait référence aux documents JPS5954156 et US4774413 qui représentent des arts antérieurs connus.

Des exemples de réalisation de l'invention seront décrits dans ce qui suit, à titre non limitatif en relation avec les figures jointes parmi lesquelles :
[Fig.1] la figure 1 est une vue latérale d'une source de matière, selon un mode de réalisation,
[Fig.2] la figure 2 est une vue en coupe axiale de la source de matière,
[Fig.3] la figure 3 représente la source de matière émettant un flux de matière sur un substrat,
[Fig.4] la figure 4 représente une courbe de répartition spatiale de la matière émise par la source de matière et déposée sur le substrat,
[Fig.5] les figures 5A, 5B, 5C représentent en coupe axiale une source d'ions, selon divers modes de réalisation.

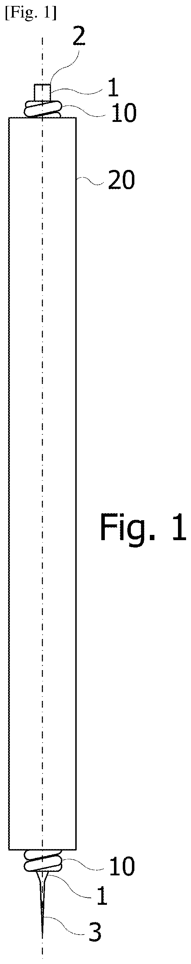

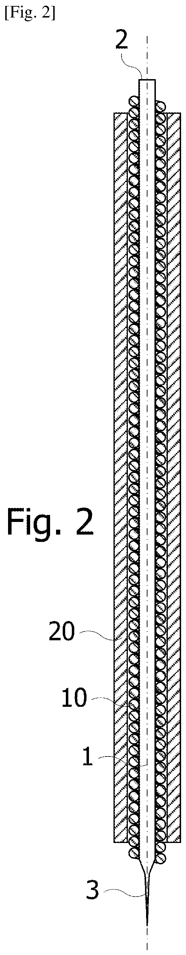

Les figures 1 à 3 représentent une source de matière selon un mode de réalisation. La source de matière comprend un tube capillaire 1, inséré dans un four comportant un écran thermique 20 renfermant une bobine 10 dans laquelle le tube capillaire 1 est engagé. La bobine est configurée pour être portée à haute température par effet joule, pour chauffer le tube 1. Le tube capillaire 1 est fermé à une extrémité 2 et présente à son autre extrémité une buse 3. Le tube capillaire 1 est rempli de la matière à projeter à l'état dense, c'est-à-dire sous forme solide ou liquide. La buse 3 présente un orifice ayant un diamètre inférieur à celui du tube 1. Dans ce qui suit, le terme "buse" désigne un embout à l'extrémité d'un conduit comportant un orifice utilisé pour éjecter un fluide du conduit.

Selon un mode de réalisation, la buse 3 est réalisée en portant une extrémité du tube 1 à sa température de fusion, ce qui tend à réduire le diamètre du tube.

Selon un autre mode de réalisation, la buse 3 est réalisée en chauffant une partie centrale d'un tube capillaire et en écartant l'une de l'autre les extrémités du tube. Ainsi, la partie chauffée du tube s'effile jusqu'à sa rupture, ce qui permet d'obtenir deux buses effilées de forme conique. Ces opérations de chauffage et d'écartement peuvent être effectuées à l'aide d'une étireuse telle que l'étireuse P2000 commercialisée par la société SUTTER INSTRUMENT^{®}. De cette manière, la buse 3 peut présenter un orifice ayant un diamètre compris entre 100 µm et 10 nm, dépendant des dimensions initiales du tube 1 et des conditions d'étirement. La buse 3 peut également être formée en portant une extrémité du tube 1 à sa température de fusion, par exemple au moyen d'un chalumeau ou d'un faisceau laser, le diamètre de l'orifice du tube 1 ayant alors tendance à diminuer avec le temps.

La fermeture de l'extrémité 2 peut être également réalisée en portant le tube 1 à sa température de fusion, par exemple au moyen d'un faisceau laser ou d'un chalumeau, suffisamment longtemps pour former une goutte qui obture totalement le conduit axial du tube. La fermeture de l'extrémité 2 est réalisée de manière à être étanche aux gaz.

La buse 3 peut être réalisée indifféremment avant ou après la fermeture de l'extrémité 2 du tube 1, et l'introduction de la matière à projeter dans le tube 1 est réalisée avant la dernière opération réalisée (fermeture de l'extrémité 2, ou formation de la buse 3). Par ailleurs, dans certaines applications, la formation de la buse 3 peut être omise si le diamètre interne du tube est suffisamment petit.

Le tube capillaire 1 peut être réalisé en céramique (alumine, zircone, mullite), en quartz, ou en verre tel que le verre borosilicaté, et le verre d'alumino-silicate. Plus généralement, le tube capillaire 1 peut être réalisé dans un matériau susceptible d'être étiré pour former la buse 3 par étirement du tube 1 préalablement chauffé à une température proche de la température de fusion du matériau dans lequel le tube est formé.

Le tube capillaire 1 peut présenter une longueur de quelques centimètres, un diamètre externe compris entre 0,1 mm et 2 mm, et un diamètre interne compris entre 0,1 mm et plusieurs mm.

L'écran thermique 20 présente la forme d'un tube cylindrique réalisé par exemple en alumine, dans lequel est insérée la bobine 10. La bobine 10 est réalisée à l'aide d'un filament 10 enroulé sur lui-même de manière à former une bobine cylindrique hélicoïdale, dans laquelle le tube capillaire 1 peut être engagé. La bobine 10 s'étend sensiblement sur toute la longueur du tube capillaire 1. La bobine 10 peut être réalisée en un métal tel que le tungstène, le tantale, ou le molybdène. Ces métaux présentent des températures de fusion relativement élevées. D'autres matériaux peuvent être utilisés si la température à atteindre est inférieure à ces températures de fusion.

La matière introduite dans le tube 1 peut être un métal, un non-métal ou un métalloïde, sous forme atomique ou moléculaire, ou bien un composé minéral ou organique tel que par exemple la paraffine.

En reliant la bobine 10 à une source de tension électrique V correspondant à une puissance de chauffage de quelques dizaines de Watts, il est possible d'atteindre une température (par exemple comprise entre 1000°C et 2000°C) choisie pour atteindre une pression de vapeur saturante souhaitée avec la matière se trouvant dans le tube 1, cette pression étant fixée par la température atteinte dans le tube. Bien entendu, cette température doit rester inférieure à la température de fusion du matériau constituant le tube 1. Le tube 1 n'étant ouvert que du côté de la buse 3, la matière sous forme vapeur est éjectée par l'orifice de la buse 3 sous l'effet de la pression de vapeur saturante apparaissant dans le tube 1 sous l'effet du chauffage. Plus la température régnant dans le tube 1 est élevée, plus la pression de valeur saturante obtenue est élevée et plus la vitesse d'éjection de la matière vaporisée en sortie de la buse est élevée. Ainsi, avec une puissance de chauffage de quelques dizaines de Watts, il est possible d'atteindre une pression de vapeur saturant de l'ordre de 1 Pa, ce qui permet d'obtenir un flux d'atomes 5 de l'ordre de 10¹⁰ à 10¹² atomes par seconde avec un diamètre d'orifice de buse 3 de 10 µm. L'extrémité de la buse 3 peut être disposée à quelques millimètres, micromètres ou dizaines de nanomètres d'une cible, par exemple un substrat 30. Dans ces conditions, un tel flux d'atomes peut permettre de produire une structure à peine plus large que le diamètre de l'orifice de la buse 3, avec une vitesse de dépôt de l'ordre de 10 à 100 couches atomiques par seconde. Il convient d'observer que plus le profil de la buse 3 est effilé, moins le flux de matière 5 en sortie de la buse diverge, un effet de focalisation du flux de matière 5 en sortie du tube capillaire 1 étant obtenu en fonction de l'effilement de la buse. L'effilement de la buse 3 peut donc être exploité pour augmenter la distance d de projection (entre l'extrémité de la buse 3 et le substrat cible 30), sans augmentation sensible du diamètre du flux de matière 5 éjecté entre la buse et le substrat.

La vitesse d'éjection des particules de matière sous forme vapeur est déterminée notamment par la pression de vapeur saturante de la matière dans le tube capillaire 1 et la géométrie du tube 1 et en particulier de la buse 3. Dans certaines conditions, cette vitesse d'éjection peut atteindre des vitesses supersoniques en raison de la pression de vapeur saturante très élevée susceptible d'être atteinte dans le tube 1 et de la détente adiabatique de la matière sous forme gazeuse lors de son éjection par l'orifice de la buse 3. Par ailleurs, il convient d'observer que le confinement dans un volume réduit avec un orifice de sortie unique et de petite section constitué par l'orifice de la buse 3 permet de maintenir une pression de vapeur saturante dans le tube qui ne reste constant tant que l'équilibre entre le matériau sous forme dense (solide ou liquide) et sous forme de vapeur est maintenu. Cette pression constante permet de maintenir constant le flux de matière éjecté par la buse 3.

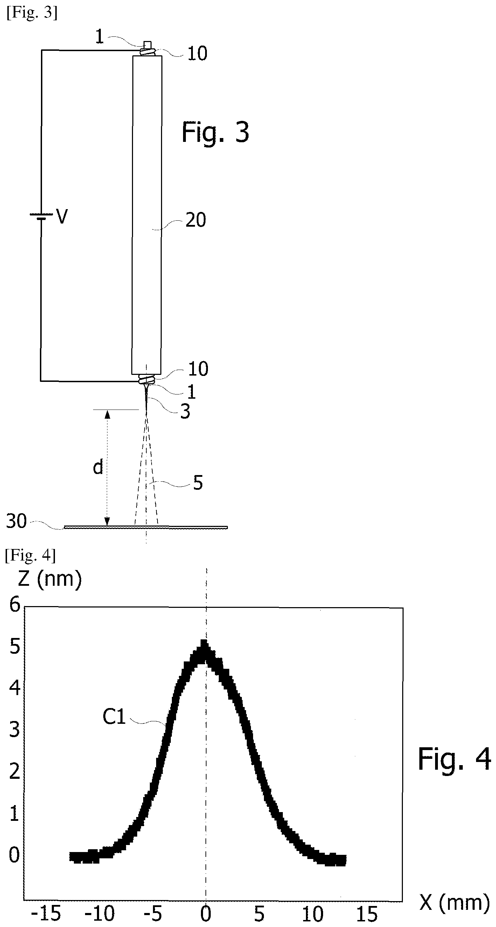

La matière placée dans le tube capillaire 1 est chauffée pour atteindre une pression de vapeur saturante souhaitée. Si la pression de vapeur saturante dans le tube est suffisante, un flux d'atomes ou de molécules est éjecté par la buse 3. La figure 4 montre un exemple de répartition de l'épaisseur de la matière sur un substrat 30 placé au voisinage de l'extrémité de la buse 3, lorsque le substrat 30 est plan et disposé perpendiculairement à la direction moyenne du flux de matière 5 à l'extrémité de la buse 3. Dans l'exemple de la figure 4, la matière projetée est de l'argent. La température de chauffage est de 1040°C. Le diamètre de la buse 3 est de 180 µm et la distance d entre l'extrémité de la buse 3 et le substrat 30 est de 10 mm. La courbe C1 de répartition de l'épaisseur de la matière sur le substrat 30 présente la forme d'une courbe de symétrique centrée sur l'axe du tube 1 et de l'orifice de la buse 3, où la courbe C1 atteint la valeur maximum d'environ 5 nm. La largeur à mi-hauteur de la courbe C1 est égale à environ 8 mm.

Il peut être observé que la distance d entre l'extrémité de la buse 3 et le substrat 30 est au minimum égale au diamètre extérieur de l'orifice de la buse 3. Cette distance peut être contrôlée par microscopie optique ou électronique ou par mesure électrique, par exemple capacitive.

En raison de ses petites dimensions, le tube capillaire 1 présente une faible inertie thermique. Ainsi, sa température peut atteindre une température supérieure à 1000°C en quelques secondes, à l'aide d'une puissance de chauffage de l'ordre de quelques dizaines de watts. Inversement, l'émission du flux de matière peut être stoppée en quelques secondes en coupant l'alimentation électrique de la bobine 10. En effet, il peut être souhaitable d'arrêter temporairement l'émission du flux de matière, notamment pour projeter la matière en un autre point de la cible.

Par ailleurs, il peut être observé que l'écran thermique 20 permet de réduire le temps de montée en température pour atteindre la pression de vapeur saturante souhaitée de la matière dans le tube capillaire 1, pour une puissance électrique donnée. En revanche, l'écran thermique 20 augmente le temps nécessaire pour stopper l'émission de matière à la suite de la coupure du courant circulant dans la bobine 10. Par conséquent, si le temps d'arrêt de la source doit être réduit, l'écran thermique 20 peut être omis partiellement ou en totalité. Le matériau formant l'écran thermique et l'épaisseur de ce dernier peuvent être choisis en fonction du temps d'arrêt souhaité de la source de matière.

Selon un autre mode de réalisation, la transmission du courant électrique à la bobine 10 peut être réalisée par induction à l'aide d'une bobine primaire placée à proximité de la bobine 10, par exemple autour de l'écran thermique 20.

Selon un autre mode de réalisation, dans le cas où la matière à projeter est conductrice, la bobine 10 peut être supprimée et remplacée par une bobine disposée à l'extérieur de l'écran thermique 20, par exemple autour de ce dernier. En soumettant la bobine extérieure à une tension alternative, la matière dans le tube 1 peut être chauffée directement par induction. Cette disposition permet de réduire l'inertie thermique du dispositif et donc de réduire le temps de chauffe pour déclencher l'émission de la matière et le temps d'arrêt de l'émission de l'émission de la matière.

La source de matière peut être utilisée en atmosphère ambiante ou en atmosphère contrôlée en pression et en composition, selon la matière à émettre et l'application.

L'ensemble de la source de matière et du substrat 30 peut être placé dans un dispositif dans lequel la source de matière est déplacée relativement au substrat de manière contrôlée, pour réaliser des structures tridimensionnelles dont l'épaisseur et les dimensions ont été prédéfinies, ces structures pouvant être de forme complexe.

La matière dans le tube capillaire 1 peut être également polarisée de manière à produire un flux d'ions. A cet effet, une électrode peut être insérée dans le tube capillaire 1 par l'extrémité 2 avant sa fermeture. La fermeture de l'extrémité 2 est donc réalisée en présence de cette électrode. En soumettant cette électrode interne à une certaine tension par rapport à une contre électrode externe, la matière portée à haute température dans le tube 1 peut être polarisée et ionisée. La contre électrode externe peut être soit placée en regard de la buse 3, soit elle est constituée par la bobine 10 qui sert alors à la fois de dispositif de chauffage et de contre électrode. Ainsi, le substrat 30 peut être utilisé comme contre électrode s'il est électriquement conducteur. La polarisation de la matière dans le tube 1 permet de générer en sortie de la buse 3 un flux d'ions obtenu à partir de la phase dense ou de la phase vapeur de la matière présente dans le tube 1.

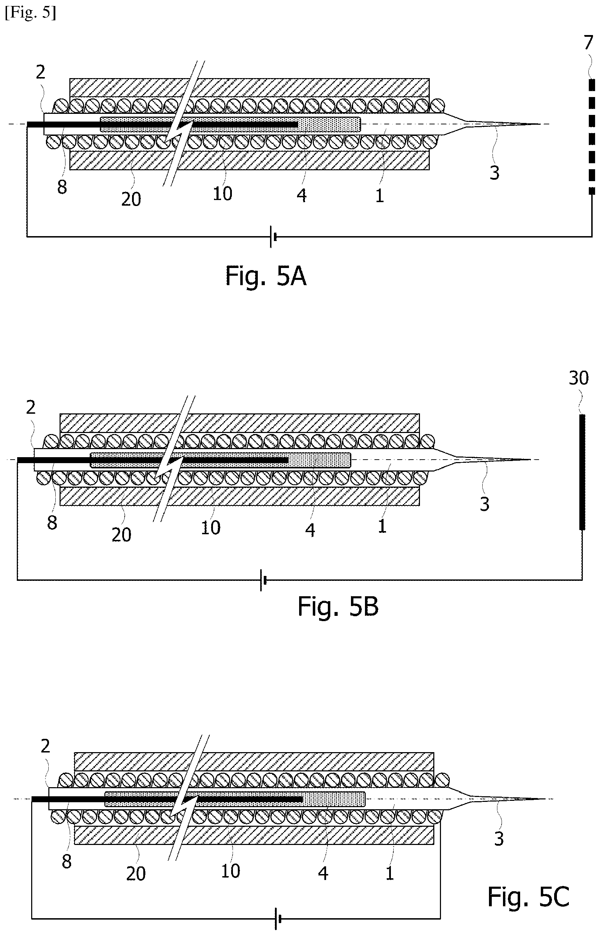

Les figures 5A, 5B, 5C représentent le tube capillaire 1 comportant une électrode interne 8 disposée à l'intérieur du tube 1 et une électrode externe disposée à l'extérieur du tube capillaire 1. L'électrode interne 8 peut être un simple fil noyé, lors de l'opération de fermeture du tube, dans le matériau fermant le tube 1 à l'extrémité 2 opposée à la buse 3, l'électrode interne 8 étant disposée de manière à venir en contact électrique avec la matière 4 dans le tube capillaire 1. Le matériau choisi pour former l'électrode interne 8 présente donc une température de fusion supérieure à celle du tube 1 et donc supérieure à la température à laquelle est portée la matière 4 dans le tube 1. De cette manière, la fermeture de l'extrémité 2 du tube 1 peut être réalisée de manière étanche en portant l'extrémité 2 du tube à sa température de fusion. Si nécessaire, la fermeture de l'extrémité 2 du tube peut être réalisée sous atmosphère contrôlée pour éviter une oxydation de l'électrode 8. Dans le cas où les ions à produire sont positifs, l'électrode interne 8 est soumise à un potentiel supérieur à celui appliqué à l'électrode externe.

Sur la figure 5A, l'électrode externe est constituée par une grille métallique 7 disposée entre la buse 3 et le substrat cible 30 (non représenté sur la figure 5A). Ainsi, l'électrode externe 7 crée dans le voisinage de la buse 3, avec la matière en contact avec l'électrode interne 8 un champ électrique parallèle à l'axe du tube 1. Ce champ électrique donne aux ions ainsi produits une accélération dans la direction d'éjection de la matière par la buse 3.

Sur la figure 5B, l'électrode externe est constituée par le substrat 30 en un matériau électriquement conducteur. Ainsi, le champ électrique produit est sensiblement le même que dans le dispositif de la figure 5A.

Sur la figure 5C, l'électrode externe est constituée par la bobine de chauffage 10.

Il apparaîtra clairement à l'homme de l'art que la présente invention est susceptible de diverses variantes de réalisation et diverses applications. En particulier, l'invention n'est pas limitée à un tube capillaire présentant une buse effilée. En effet, le diamètre intérieur du tube 1 peut être suffisamment petit pour qu'une telle buse ne soit pas nécessaire.

L'invention n'est pas non plus limitée au dispositif de chauffage précédemment décrit. Tout autre moyen de chauffage connu permettant de chauffer le tube capillaire 1 peut en effet être utilisé, dès lors que la température atteinte reste inférieure à la température de fusion du tube, et compte tenu qu'une faible inertie thermique n'est pas nécessairement requise dans toutes les applications envisageables.

## Revendications

1. Procédé pour émettre un flux de matière, le procédé comprenant des étapes consistant à :
prévoir un tube capillaire (1) comportant au moins une ouverture formant une buse (3),
introduire de la matière à émettre sous forme solide ou liquide, dans le tube capillaire, et
disposer le tube capillaire de manière à ce que la buse soit orientée vers une cible (30),
**caractérisé en ce qu'**il comprend une étape de chauffage du tube capillaire à une température correspondant à une pression de vapeur saturante souhaitée de la matière présente dans le tube, pour éjecter la matière sous forme vapeur hors du tube par la buse.

2. Procédé selon la revendication 1, comprenant une étape de fermeture d'une première extrémité ouverte (2) du tube capillaire (1) en chauffant le tube capillaire à une température de fusion du tube capillaire, au voisinage de la première extrémité ouverte.

3. Procédé selon la revendication 1 ou 2, comprenant une étape de formation de la buse (3) en chauffant une seconde extrémité ouverte du tube capillaire (1) à une température de fusion du tube capillaire, la buse présentant un orifice de sortie ayant un diamètre inférieur à un diamètre interne du tube capillaire.

4. Procédé selon la revendication 1 ou 2, dans lequel la buse (3) présente un profil effilé obtenu en chauffant une partie centrale du tube capillaire (1) au voisinage de sa température de fusion, et en écartant les extrémités du tube capillaire pour étirer la partie centrale chauffée.

5. Procédé selon l'une des revendications 1 à 4, comprenant une étape d'arrêt du chauffage du tube capillaire (1) pour stopper l'émission du flux de matière.

6. Procédé selon l'une des revendications 1 à 5, dans lequel le chauffage du tube capillaire (1) pour émettre la matière, est réalisé en plaçant le tube capillaire dans un four (10, 20).

7. Procédé selon l'une des revendications 1 à 6, comprenant des étapes de déplacement relatif, de manière contrôlée, du tube capillaire (1) par rapport à un substrat (30), pendant que le tube capillaire est chauffé, pour former sur le substrat des structures de formes et d'épaisseurs prédéfinies.

8. Procédé selon l'une des revendications 1 à 7, comprenant une étape d'ionisation de la matière dans le tube capillaire (1) au moyen d'un champ électrique généré dans le tube capillaire (1).

9. Procédé selon l'une des revendications 1 à 8, comprenant une étape de placement de la source de matière dans une atmosphère contrôlée en pression et/ou en composition.

10. Dispositif pour émettre un flux de matière vaporisée, le dispositif comprenant :
un tube capillaire (1) renfermant la matière à émettre, le tube capillaire étant fermé à une première extrémité, et comportant une buse de sortie (3) de la matière à une seconde extrémité, et
un dispositif de chauffage (10, 20) dans lequel le tube capillaire est disposé,
**caractérisé en ce qu'**il comprend un organe de commande du dispositif de chauffage pour déclencher l'émission d'un flux de matière vaporisée hors du tube par la buse en activant le chauffage du tube capillaire à une température correspondant à une pression de vapeur saturante souhaitée de la matière présente dans le tube, ou stopper l'émission du flux de matière vaporisée.

11. Dispositif selon la revendication 10, dans lequel la buse présente un profil effilé (3).

12. Dispositif selon la revendication 10 ou 11, dans lequel le dispositif de chauffage comprend une bobine (10) formant un logement cylindrique dans lequel le tube capillaire (1) est introduit, la bobine étant configurée pour :
produire de la chaleur par effet Joule lorsqu'elle est traversée par un courant électrique, le courant électrique étant fourni à la bobine par conduction ou par induction, ou bien
chauffer directement par induction la matière (4) dans le tube capillaire.

13. Dispositif selon la revendication 12, dans lequel le dispositif de chauffage comprend un écran thermique (20) entourant le tube capillaire (1).

14. Dispositif selon l'une des revendications 10 à 13, comprenant un dispositif de déplacement relatif, de manière contrôlée, du tube capillaire (1) par rapport à un substrat (30), la buse (3) étant placée en regard du substrat, pour former une micro- ou nanostructure sur le substrat.

15. Dispositif selon l'une des revendications 10 à 14, comprenant une électrode interne (8) et une électrode externe (7, 10, 30) disposées respectivement dans le tube capillaire (1) et à l'extérieur du tube capillaire, pour générer un champ électrique apte à ioniser la matière avant son éjection hors du tube capillaire.

## Patentansprüche

1. Verfahren zum Emittieren eines Materialflusses, das Verfahren umfassend Schritte, die bestehen aus:
Bereitstellen eines Kapillarrohrs (1), das mindestens eine Öffnung aufweist, die eine Düse (3) bildet,
Einführen des zu emittierenden Materials in fester oder flüssiger Form in das Kapillarrohr, und
Anordnen des Kapillarrohrs so, dass die Düse in Richtung eines Ziels (30) ausgerichtet ist,
**dadurch gekennzeichnet, dass** es einen Schritt eines Erhitzens des Kapillarrohrs auf eine Temperatur umfasst, die einem gewünschten Sättigungsdampfdruck des Materials entspricht, das in dem Rohr vorhanden ist, zum Ausstoßen des Materials in Dampfform aus dem Rohr durch die Düse.

2. Verfahren nach Anspruch 1, umfassend einen Schritt eines Verschließens eines ersten offenen Endes (2) des Kapillarrohrs (1), indem das Kapillarrohr auf eine Schmelztemperatur des Kapillarrohrs erhitzt wird, in der Nähe des ersten offenen Endes.

3. Verfahren nach Anspruch 1 oder 2, umfassend einen Schritt eines Ausbildens der Düse (3), indem ein zweites offenes Ende des Kapillarrohrs (1) auf eine Schmelztemperatur des Kapillarrohrs erhitzt wird, wobei die Düse ein Austrittsloch vorweist, das einen Durchmesser besitzt, der kleiner als der Innendurchmesser des Kapillarrohrs ist.

4. Verfahren nach Anspruch 1 oder 2, wobei die Düse (3) ein verjüngtes Profil vorweist, das erhalten wird, indem ein Mittelteil des Kapillarrohrs (1) in die Nähe seiner Schmelztemperatur erhitzt wird, und indem die Enden des Kapillarrohrs zum Dehnen des erhitzten Mittelteils weggerückt werden.

5. Verfahren nach einem der Ansprüche 1 bis 4, umfassend einen Schritt eines Anhaltens des Erhitzens des Kapillarrohrs (1) zum Stoppen der Emission des Materialflusses.

6. Verfahren nach einem der Ansprüche 1 bis 5, wobei das Erhitzen des Kapillarrohrs (1) zum Emittieren des Materials durchgeführt wird, indem das Kapillarrohr in einen Ofen (10, 20) platziert wird.

7. Verfahren nach einem der Ansprüche 1 bis 6, umfassend Schritte einer Relativbewegung, auf kontrollierte Weise, des Kapillarrohrs (1) relativ zu einem Substrat (30), während das Kapillarrohr erhitzt wird, zum Ausbilden von Strukturen mit Formen und vordefinierten Dicken auf dem Substrat.

8. Verfahren nach einem der Ansprüche 1 bis 7, umfassend einen Schritt eines lonisierens des Materials in dem Kapillarrohr (1) mittels eines elektrischen Feldes, das in dem Kapillarrohr (1) erzeugt wird.

9. Verfahren nach einem der Ansprüche 1 bis 8, umfassend einen Schritt des Platzierens der Quelle des Materials in einer Atmosphäre mit kontrolliertem Druck und/oder kontrollierter Zusammensetzung.

10. Vorrichtung zum Emittieren eines Flusses von verdampftem Material, die Vorrichtung umfassend:
ein Kapillarrohr (1), das das zu emittierenden Material einschließt, wobei das Kapillarrohr an einem ersten Ende verschlossen ist und eine Austrittsdüse (3) des Materials an einem zweiten Ende aufweist, und
eine Erhitzungsvorrichtung (10, 20), in der das Kapillarrohr angeordnet ist,
**dadurch gekennzeichnet, dass** sie ein Mittel zum Steuern der Erhitzungsvorrichtung zum Auslösen der Emission eines Flusses von verdampftem Material aus dem Rohr durch die Düse umfasst, indem die Erhitzung des Kapillarrohrs auf eine Temperatur, die einem gewünschten Sättigungsdampfdruck des Materials entspricht, das in dem Rohr vorhanden ist, oder das Stoppen der Emission des Flusses von verdampftem Material umfasst.

11. Vorrichtung nach Anspruch 10, wobei die Düse ein verjüngtes Profil (3) vorweist.

12. Verfahren nach Anspruch 10 oder 11, wobei die Erhitzungsvorrichtung eine Spule (10) umfasst, die ein zylindrisches Gehäuse ausbildet, in das das Kapillarrohr (1) eingeführt wird, wobei die Spule konfiguriert ist zum:
Produzieren der Wärme durch einen Joule-Effekt, wenn sie durch einen elektrischen Strom durchflossen wird, wobei der elektrische Strom der Spule durch Leitung oder durch Induktion zugeführt wird, oder direktes Erhitzen durch Induktion des Materials (4) in dem Kapillarrohr.

13. Vorrichtung nach Anspruch 12, wobei die Erhitzungsvorrichtung einen Wärmeschild (20) umfasst, der das Kapillarrohr (1) umgibt.

14. Verfahren nach einem der Ansprüche 10 bis 13, umfassend eine Vorrichtung der Relativbewegung, auf kontrollierte Weise, des Kapillarrohrs (1) relativ zu einem Substrat (30), wobei die Düse (3) gegenüber dem Substrat platziert wird, zum Ausbilden einer Mikro- oder Nanostruktur auf dem Substrat.

15. Vorrichtung nach einem der Ansprüche 10 bis 14, umfassend eine Innenelektrode (8) und eine Außenelektrode (7, 10, 30), die in dem Kapillarrohr (1) beziehungsweise auf der Außenseite des Kapillarrohrs angeordnet sind, zum Erzeugen eines elektrischen Feldes, das geeignet ist, um das Material vor seinem Ausstoßen aus dem Kapillarrohr zu ionisieren.

## Claims

1. A method for emitting a flow of material, the method comprising the steps of:
providing a capillary tube (1) having at least one opening forming a nozzle (3),
introducing material to be emitted in solid or liquid form into the capillary tube, and
arranging the capillary tube so that the nozzle is directed towards a target (30),
**characterised in that** it comprises a step of heating the capillary tube to a temperature corresponding to a desired saturation vapour pressure of the material present in the tube, in order to eject the material in vapour form from the tube through the nozzle.

2. The method according to claim 1, comprising a step of closing a first open end (2) of the capillary tube (1) by heating the capillary tube to a melting temperature of the capillary tube, in the vicinity of the first open end.

3. The method according to claim 1 or 2, comprising a step of forming the nozzle (3) by heating a second open end of the capillary tube (1) to a melting temperature of the capillary tube, the nozzle having an outlet having a diameter smaller than an inner diameter of the capillary tube.

4. The method according to claim 1 or 2, wherein the nozzle (3) has a tapered profile obtained by heating a central part of the capillary tube (1) close to its melting temperature, and by pulling the ends of the capillary tube in opposite directions to stretch the heated central part.

5. The method according to one of claims 1 to 4, comprising a step of stopping the heating of the capillary tube (1) to stop the emission of the flow of material.

6. The method according to any of claims 1 to 5, wherein heating of the capillary tube (1) to emit the material is carried out by placing the capillary tube in an oven (10, 20).

7. The method according to any of claims 1 to 6, comprising the steps of moving the capillary tube (1) relative to a substrate (30) in a controlled manner, while the capillary tube is heated, to form structures of predefined shapes and thicknesses on the substrate.

8. The method according to one of claims 1 to 7, comprising a step of ionising the material in the capillary tube (1) by means of an electric field generated in the capillary tube (1).

9. The method according to one of claims 1 to 8, comprising a step of placing the source of material in an atmosphere controlled in pressure and/or composition.

10. A device for emitting a flow of vaporised material, the device comprising:
a capillary tube (1) containing the material to be emitted, the capillary tube being closed at a first end and having an outlet nozzle (3) for the material at a second end, and
a heating device (10, 20) in which the capillary tube is arranged,
**characterised in that** it comprises a component for controlling the heating device in order to trigger the emission of a flow of vaporised material from the tube through the nozzle by activating the heating of the capillary tube to a temperature corresponding to a desired saturation vapour pressure of the material present in the tube, or to stop the emission of the flow of vaporised material.

11. The device as claimed in claim 10, wherein the nozzle has a tapered profile (3).

12. The device according to claim 10 or 11, wherein the heating device comprises a coil (10) forming a cylindrical housing into which the capillary tube (1) is inserted, the coil being configured to:
produce heat by Joule effect when an electric current is applied to it, the electric current being supplied to the coil by conduction or induction, or
directly heat the material (4) in the capillary tube by induction.

13. The device as claimed in claim 12, wherein the heating device comprises a heat shield (20) surrounding the capillary tube (1).

14. The device according to one of claims 10 to 13, comprising a device for relatively displacing, in a controlled manner, the capillary tube (1) with respect to a substrate (30), the nozzle (3) being placed opposite the substrate, in order to form a micro- or nanostructure on the substrate.

15. The device according to one of claims 10 to 14, comprising an internal electrode (8) and an external electrode (7, 10, 30) arranged respectively in the capillary tube (1) and outside the capillary tube, to generate an electric field capable of ionising the material before it is ejected from the capillary tube.
